# EUROPEAN PATENT APPLICATION

(11) **EP 4 525 034 A1**
(43) Date of publication of application: **19.03.2025**
(21) Application number: 24199823.6
(22) Date of filing: 11.09.2024
(51) Int. Cl.: H01L 23/053, H01L 23/16, H01L 25/07

(54) **PHOTOVOLTAIC OPTIMIZER AND PACKAGE STRUCTURE**

(30) Priority: 14.09.2023 CN 202311193919
(71) Applicant: Huawei Digital Power Technologies Co., Ltd., Shenzhen, Guangdong 518043 (CN)
(72) Inventor: WU, Baoshan, Shenzhen, 518043 (CN); DENG, Guoliang, Shenzhen, 518043 (CN); WANG, Qinglei, Shenzhen, 518043 (CN); SONG, Niancong, Shenzhen, 518043 (CN)
(74) Representative: Gill Jennings & Every LLP

(57) **Abstract**

This application discloses a photovoltaic optimizer and a package structure. The photovoltaic optimizer includes a first housing and the package structure accommodated in the first housing. The package structure includes a first substrate, a package module, a circuit board, and a conductor. The first substrate includes a first metal layer, an insulation layer, and a metal substrate. The package module includes a second substrate, a power device, and a first pin. The second substrate includes a second metal layer, an insulation substrate, and a third metal layer. Based on this, heat generated by the power device is transferred to the first substrate via the second substrate, and then is transferred to a bottom plate via the first substrate. The heat is dissipated to the outside via the bottom plate, a heat dissipation protrusion, or a heat dissipation fin. In addition, the conductor connects the second metal layer to a ground potential pad on the circuit board, and a surface of a side that is of the second metal layer and that faces away from the insulation substrate is connected to a surface of a side that is of the first metal layer and that faces away from the insulation layer, so that the second metal layer and the first metal layer are combined with each other to serve as an electromagnetic shield layer. This implements electromagnetic shielding.

## Description

### TECHNICAL FIELD

This application relates to the field of electronic product technologies, and in particular, to a photovoltaic optimizer and a package structure.

### BACKGROUND

Package structures are widely used in products such as photovoltaic optimizers, power modules, and other potting or plastic packaging products. Usually, a package structure integrates a power device, such as a metal-oxide-semiconductor ( MOS) field-effect transistor. Because the MOS transistor has a high switching frequency, in a process of frequently turning on and turning off the MOS transistor, a magnetic field that changes at a high frequency is generated in a surrounding environment, and a high-order harmonic component is induced in a circuit. If the power device is directly connected to a power grid, a high-order harmonic wave is injected into the power grid, deteriorating electric energy quality of the power grid. In addition, during operation, a large current up to tens of amperes may usually flow through the MOS transistor. If the MOS transistor is frequently turned on and turned off, a switching loss and a conduction loss are generated in the MOS transistor, and these energy losses may be released in a form of heat energy. If the heat energy released by the MOS transistor cannot be transferred to the outside in time, the MOS transistor is exposed to a risk of being burnt out at a high temperature. This affects overall reliability of the package structure.

### SUMMARY

Embodiments of this application provide a photovoltaic optimizer and a package structure, to implement heat dissipation and electromagnetic shielding, and improve overall reliability of the photovoltaic optimizer.

According to a first aspect, an embodiment of this application provides a photovoltaic optimizer. The photovoltaic optimizer includes a first housing and a package structure. The first housing includes a cover plate, a bottom plate, and a side wall. The side wall is fastened between the cover plate and the bottom plate. An outer wall of a side that is of the bottom plate and that faces away from the cover plate is provided with a heat dissipation protrusion or a heat dissipation fin extending outward. The cover plate, the bottom plate, and the side wall form a closed structure having accommodation space. The package structure is disposed in the accommodation space, that is, the first housing has the accommodation space inside, and the package structure is disposed inside the first housing. In addition, the package structure includes a first substrate, a package module, a circuit board, and a conductor. The first substrate includes a first metal layer, an insulation layer, and a metal substrate that are sequentially disposed in a stacked manner. The first metal layer is located on a side that is of the insulation layer and that faces a second substrate, and a surface of a side that is of the metal substrate and that faces away from the insulation layer is in direct contact with an inner wall of a side that is of the bottom plate and that faces the cover plate. In addition, the package module includes the second substrate, a power device, and a first pin. The second substrate includes a second metal layer, an insulation substrate, and a third metal layer that are sequentially disposed in a stacked manner. The power device is located on a surface of a side that is of the third metal layer and that faces away from the insulation substrate, the third metal layer has a drive line connected to the power device, and the first pin connects the drive line to a drive pad on the circuit board. Based on this, the first substrate is used as a baseboard of the package module, and the metal substrate is directly in contact with the inner wall of the bottom plate. The outer wall of the bottom plate is provided with the heat dissipation protrusion or the heat dissipation fin, and the heat dissipation protrusion or the heat dissipation fin can increase a heat dissipation area of the bottom plate. In this way, when the power device operates, heat generated by the power device may be transferred to the first substrate via the second substrate, and the heat transferred to the first substrate may be dissipated to the outside as soon as possible via a heat dissipation path sequentially passing through the metal substrate, the bottom plate, and the heat dissipation protrusion or the heat dissipation fin, to implement heat dissipation for the heat generated by the power device. This can simplify a structure, reduce a module size, and reduce costs. In addition, this can further reduce total thermal resistance on a heat conducting path, dissipate the heat generated by the power device to the outside as soon as possible in time, and improve a heat dissipation function.

In addition, an orthographic projection that is of the second metal layer and that is on the circuit board covers an orthographic projection that is of the power device and that is on the circuit board, and the conductor connects the second metal layer to a ground potential pad on the circuit board, so that the second metal layer can be connected to a ground potential. Moreover, a surface of a side that is of the second metal layer and that faces away from the insulation substrate is connected to a surface of a side that is of the first metal layer and that faces away from the insulation layer, so that the second metal layer and the first metal layer may be combined with each other to serve as an electromagnetic shield layer. This implements electromagnetic shielding for a magnetic field generated by the power device. Further, insulation can be implemented by using the insulation layer in the first substrate, simplifying a structure design and reducing production difficulty and costs.

In addition, the heat dissipation protrusion or the heat dissipation fin can increase the heat dissipation area of the bottom plate, to improve heat dissipation efficiency of the bottom plate and further improve heat dissipation efficiency of the photovoltaic optimizer. Specifically, the heat dissipation protrusion or the heat dissipation fin may be made of a metal material or the like. When the heat dissipation protrusion or the heat dissipation fin and the first housing are both made of a metal material, the heat dissipation protrusion or the heat dissipation fin may be integrally formed with the first housing. For example, the bottom plate and the side wall in the first housing may be integrally formed, and the bottom plate and the side wall may be clamped, welded, or riveted using a screw, to form the closed structure having the accommodation space.

Furthermore, disposing the first housing further helps the package structure resist an external force.

In some embodiments, the photovoltaic optimizer can further include a second housing. The second housing is accommodated inside the first housing. The package structure is disposed inside the second housing. In addition, to improve the heat dissipation function, a side that is of the second housing and that faces away from the metal substrate is provided with a first opening, so that the metal substrate is in contact with the first housing through the first opening. In this way, heat on the metal substrate is directly transferred to the first housing, and heat can be directly dissipated via the first housing. During specific implementation, the first housing is made of a metal material, to further improve the heat dissipation function. In addition, the first housing is further connected to a ground, to connect the metal substrate to the ground, implementing grounding protection.

Moreover, to further improve the heat dissipation function, the second housing is filled with a heat-conducting medium as a whole, and the heat-conducting medium is a potting material or the like. In this way, the heat-conducting medium and the package structure are used to fill internal space of the second housing, and the heat-conducting medium is in contact with the package structure, accelerating heat dissipation of the package structure.

Further, the heat dissipation protrusion or the heat dissipation fin may be disposed on a side, that is of the first housing and that faces away from the metal substrate, and extends outward. Specifically, a bottom plate of the second housing is in contact with the bottom plate of the first housing, and the heat dissipation protrusion or the heat dissipation fin may be disposed on the bottom plate that is of the first housing and that faces away from the metal substrate, so that the heat dissipation protrusion or the heat dissipation fin may be disposed close to the metal substrate, accelerating heat dissipation of the metal substrate. In addition to being disposed on the bottom plate of the first housing, the heat dissipation protrusion or the heat dissipation fin may alternatively be disposed on the side wall of the first housing.

In some embodiments, a cover plate may further be disposed on the first housing, so that the first housing is mounted and connected to another structure. Specifically, the cover plate may be made of a metal material. The cover plate may be of a plate structure, and the cover plate may be disposed at a third opening of the first housing. Specifically, a groove structure may be provided at the third opening of the first housing, and the cover plate may be inserted into the groove structure, so that the cover plate is connected to the first housing.

In some embodiments, the surface of the side that is of the second metal layer and that faces away from the insulation substrate is directly welded to the surface of the side that is of the first metal layer and that faces away from the insulation layer in a welding manner, so that the surface of the side that is of the second metal layer and that faces away from the insulation substrate is in direct contact with the surface of the side that is of the first metal layer and that faces away from the insulation layer. In this way, heat conducted to the second metal layer can be directly conducted to the first metal layer, and then dissipated to the outside as soon as possible via the insulation layer and the metal substrate, improving the heat dissipation function. Alternatively, the surface of the side that is of the second metal layer and that faces away from the insulation substrate and the surface of the side that is of the first metal layer and that faces away from the insulation layer may be connected together by using a thermal interface material. In this way, heat conducted to the second metal layer can be conducted to the first metal layer by using the thermal interface material, and then dissipated to the outside as soon as possible via the insulation layer and the metal substrate.

In some embodiments, considering a requirement for electromagnetic shielding, an orthographic projection that is of the first metal layer and that is on the circuit board covers orthographic projections that are of the second metal layer and the third metal layer and that are on the circuit board. Alternatively, an orthographic projection that is of the first metal layer and that is on the circuit board overlaps orthographic projections that are of the second metal layer and the third metal layer and that are on the circuit board. Further, the orthographic projection that is of the first metal layer and that is on the circuit board covers an orthographic projection that is of the second substrate and that is on the circuit board, so that electromagnetic shielding can be further performed on the magnetic field generated by the power device. Alternatively, the orthographic projection that is of the first metal layer and that is on the circuit board may overlap an orthographic projection that is of the second substrate and that is on the circuit board.

In some embodiments, an orthographic projection that is of the insulation layer and that is on the circuit board covers the orthographic projection that is of the first metal layer and that is on the circuit board. In actual application, the metal substrate is further in contact with the housing, and the housing is connected to the ground, so that the metal substrate is connected to the ground. However, during operation, a large current up to tens of amperes may usually flow through the power device. Considering a safety regulation requirement, during specific implementation, a thickness of the insulation layer further needs to be greater than or equal to 0.2 mm, to meet a requirement of enhanced insulation in the safety regulation. During specific implementation, the insulation layer is made of, for example, a polypropylene (polypropylene, PP) material. Certainly, the insulation layer may alternatively be made of another material that can implement enhanced insulation. This is not limited herein.

In some embodiments, the third metal layer is further provided with a conversion part that is insulated from the drive line, and the insulation substrate is provided with a through connection hole. In addition, to ground the second metal layer, the conductor includes a second pin and a conversion member. The conversion member electrically connects the conversion part to the second metal layer through the connection hole, and the second pin connects the conversion part to the ground potential pad. In this way, the second pin, the conversion part, and the conversion member are used to connect the second metal layer and the first metal layer to the ground potential pad, so that the second metal layer and the first metal layer have the ground potential. This ensures stability and reliability of a structure and enhances system reliability.

In some embodiments, the conversion member may be disposed as a metal material layer with which the connection hole is filled. During process preparation, the metal material layer is deposited in the connection hole by using a metal material, so that the metal material layer fills the connection hole, and the metal material layer and the conversion part are electrically connected to each other. In this way, the metal material layer and the second pin may be used to ground the first metal layer and the second metal layer, to implement an electromagnetic shielding function. In addition, the metal material layer and the second pin are used to ground the first metal layer and the second metal layer, so that stability and reliability of a structure can be ensured, and system reliability can be enhanced.

In some embodiments, the conversion member may alternatively be disposed as a metal material layer covering a side wall of the connection hole. During process preparation, the metal material layer is deposited on the side wall of the connection hole by using a metal material, so that the metal material layer and the conversion part are electrically connected to each other. In this way, the metal material layer and the second pin may be used to ground the first metal layer and the second metal layer, to implement the electromagnetic shielding function.

In some embodiments, the conversion member is disposed as a metal wire. The metal wire may be formed by using a wire bonding (wire bonding, WB) process, so that the metal wire passes through the connection hole to electrically connect the conversion part to the second metal layer. In this way, the metal wire and the second pin may be used to ground the first metal layer and the second metal layer, to implement the electromagnetic shielding function. In addition, the metal wire and the second pin are used to ground the first metal layer and the second metal layer, so that stability and reliability of a structure can be ensured, and system reliability can be enhanced. Certainly, the conversion member may alternatively be disposed as a metal strip. This is not limited herein.

In some embodiments, the connection hole is provided with a top of a side facing away from the first substrate. A first spacing exists between the conversion part and an edge of the top of the connection hole. The first spacing is greater than or equal to a first specified safety regulation distance, to meet the safety regulation requirement. A fifth spacing exists between the drive line and the edge of the top of the connection hole. The fifth spacing is greater than or equal to the first specified safety regulation distance, to meet the safety regulation requirement. For example, the first spacing may be the same as the fifth spacing. Certainly, the first spacing may alternatively be greater than or less than the fifth spacing.

In some embodiments, the connection hole is provided with a bottom of a side facing the first substrate. A second spacing exists between the second metal layer and an edge of the bottom of the connection hole. The second spacing is greater than or equal to a second specified safety regulation distance, to meet the safety regulation requirement.

In some embodiments, the conductor may alternatively be disposed as a metal column. A first end of the metal column is connected to the ground potential pad on the circuit board, and a second end of the metal column is connected to the first metal layer. In this way, the metal column may be used to ground the first metal layer and the second metal layer, to implement the electromagnetic shielding function. In addition, the metal column is used to ground the first metal layer and the second metal layer, so that stability and reliability of a structure can be ensured, and system reliability can be enhanced.

During specific implementation, the first metal layer may have a shield component, a shield line, and a shield connection component. The shield component may be of an entire-plane structure. A surface of a side that is of the shield component and that faces away from the insulation layer is connected to a surface of a side that is of the second metal layer and that faces away from the insulation substrate through welding or by using a thermal interface material. In addition, the shield component is electrically connected to the shield connection component by using the shield line, and the shield connection component is connected to the second end of the metal column. In this way, the metal column may be used to ground the first metal layer and the second metal layer. Certainly, the first metal layer may alternatively be disposed as an entire-plane structure.

In some embodiments, the second metal layer is disposed as an entire-plane structure, and a shape of the second metal layer is approximately the same as a shape of the insulation substrate. In addition, to implement the safety regulation requirement, a fourth spacing may exist between an edge of the second metal layer and an edge of the insulation substrate. The fourth spacing is greater than or equal to a third specified safety regulation distance, to meet the safety regulation requirement. In addition, a third spacing exists between the drive line and the edge of the insulation substrate. The third spacing is greater than or equal to the third specified safety regulation distance, to meet the safety regulation requirement. For example, the third spacing may be the same as the fourth spacing. Certainly, the third spacing may alternatively be greater than or less than the fourth spacing.

Considering a heat dissipation requirement of the power device, during specific implementation, the second substrate may be disposed as a copper-clad ceramic (direct bonding copper, DBC) substrate or a copper-plated ceramic (Direct Plate Copper, DPC) substrate, so that each of the second metal layer and the third metal layer is made of copper. In this case, the heat generated when the power device operates is dissipated to the outside as soon as possible by using excellent heat conducting performance of the DBC or the DPC, to further improve a heat dissipation function.

To dissipate the heat generated by the power device to the outside as soon as possible, the first substrate may further be disposed as an aluminum substrate with a good heat dissipation function, to further reduce total thermal resistance on the heat conducting path and improve the heat dissipation function.

In some embodiments, the package module further includes a package adhesive. The package adhesive wraps at least a side that is of the second metal layer and that faces the insulation substrate, that is, wraps both the insulation substrate and the power device. In addition, the package adhesive further wraps some regions of the first pin. Specifically, a first end of the first pin is connected to the drive line, and a second end of the first pin extends to the outside of the package adhesive and is connected to the drive pad. In addition, the package adhesive exposes the surface of the side that is of the second metal layer and that faces away from the insulation substrate, so that the surface of the side that is of the second metal layer and that faces away from the insulation substrate can be connected to a surface of a side that is of the first metal layer and that faces the second metal layer, improving a heat dissipation function. Moreover, the side that is of the second metal layer and that faces the insulation substrate is wrapped by using the package adhesive, so that lines in the third metal layer and the power device may further be protected.

In some embodiments, when the conductor includes the second pin and the conversion member, the package adhesive further wraps some regions of the second pin. Specifically, a first end of the second pin is electrically connected to the conversion part, and a second end of the second pin extends to the outside of the package adhesive and is connected to the ground potential pad.

According to a second aspect, an embodiment of this application further provides a package structure. The package structure includes a first substrate, a package module, a circuit board, and a conductor. The first substrate includes a first metal layer, an insulation layer, and a metal substrate that are sequentially disposed in a stacked manner. The first metal layer is located on a side that is of the insulation layer and that faces a second substrate. In addition, the package module includes the second substrate, a power device, and a first pin. The second substrate includes a second metal layer, an insulation substrate, and a third metal layer that are sequentially disposed in a stacked manner. The power device is located on a surface of a side that is of the third metal layer and that faces away from the insulation substrate, the third metal layer has a drive line connected to the power device, and the first pin connects the drive line to a drive pad on the circuit board. Based on this, when the package module operates, heat generated by the power device may be transferred to the first substrate via the second substrate, and then the heat is dissipated to the outside via the first substrate. In this way, the heat generated by the power device is dissipated by combining the first substrate and the second substrate with each other. This can simplify a structure, reduce a module size, and reduce costs. In addition, this can further reduce total thermal resistance on a heat conducting path, dissipate the heat generated by the power device to the outside as soon as possible in time, and improve a heat dissipation function.

In addition, the package structure is the package structure of the photovoltaic optimizer according to the first aspect or the possible designs of the first aspect. For another implementation of the package structure, refer to the implementation of the package structure in the photovoltaic optimizer. Repeated details are not described again.

According to a third aspect, an embodiment of this application further provides a photovoltaic system. The photovoltaic system includes a power converter, a photovoltaic module, and a photovoltaic optimizer. An input end of the photovoltaic optimizer is connected to the photovoltaic module, and an output end of the photovoltaic optimizer is connected to an input end of the power converter. The photovoltaic optimizer is configured to convert a direct current output by the photovoltaic module and output the direct current. The power converter is configured to receive the direct current output by the photovoltaic optimizer, and convert the received direct current into an alternating current or a direct current. In addition, the photovoltaic optimizer is the photovoltaic optimizer according to the first aspect or the possible designs of the first aspect. A principle of the photovoltaic system to resolve problems is similar to a principle of the photovoltaic optimizer to resolve problems. Therefore, for technical effects of the photovoltaic system, refer to the technical effects of the photovoltaic optimizer. Repeated details are not described again.

### BRIEF DESCRIPTION OF DRAWINGS

FIG. 1 is a diagram of an application scenario of a photovoltaic system according to an embodiment of this application;
FIG. 2 is a schematic of a circuit topology in a photovoltaic optimizer according to an embodiment of this application;
FIG. 3a is a diagram of a structure of a photovoltaic optimizer according to an embodiment of this application;
FIG. 3b is a diagram of a structure of a package structure according to an embodiment of this application;
FIG. 4a is a top-view diagram of a structure of a second substrate according to an embodiment of this application;
FIG. 4b is a sectional diagram of a structure in an AA' direction in FIG. 4a;
FIG. 5a is a top-view diagram of a structure of another second substrate according to an embodiment of this application;
FIG. 5b is a sectional diagram of a structure in an AA' direction in FIG. 5a;
FIG. 6 is a diagram of a structure of another package structure according to an embodiment of this application;
FIG. 7a is a top-view diagram of a structure of another second substrate according to an embodiment of this application;
FIG. 7b is a sectional diagram of a structure in an AA' direction in FIG. 7a;
FIG. 8 is a diagram of a structure of another package structure according to an embodiment of this application; and
FIG. 9 is a top-view diagram of a structure of a first substrate according to an embodiment of this application.

### Reference numerals:

100: photovoltaic module; 200: photovoltaic optimizer; 300: power converter; 400: grid-connected transformer; 500: alternating current grid; 600: load; 10: driver; 20: power conversion circuit; 210: first substrate; 213: first metal layer; 212: insulation layer; 211: metal substrate; 220: package module; 230: second substrate; 231: second metal layer; 232: insulation substrate; 233: third metal layer; 240: power device; 241: first power device; 242: second power device; 2331a/2331b: drive line; 2332: conversion part; 250: first pin; 260: circuit board; 270: conductor; 271: second pin; 272: conversion member; 2721: metal material layer; 2722: metal wire; 273: metal column; 280: package adhesive; 2131: shield component; 2132 shield line; 2133: shield connection component; 291: drive pad; 292: ground potential pad; 293: second housing; 294: heat-conducting medium; 295: first housing; 296: cover plate; 297: heat dissipation protrusion; 298: bottom plate; 299: side wall; KX1: connection hole; d1: first spacing; d2: second spacing; d3: third spacing; d4: fourth spacing; d5: fifth spacing.

### DESCRIPTION OF EMBODIMENTS

To make the objectives, technical solutions, and advantages of this application clearer, the following further describes this application in detail with reference to the accompanying drawings. A specific operation method in a method embodiment may also be applied to an apparatus embodiment or a system embodiment. It should be noted that in the descriptions of this application, the term "a plurality of" is understood as "at least two". In addition, it should be understood that terms such as "first" and "second" in the descriptions in this application are merely used for distinguishing and description, but should not be understood as indicating or implying relative importance, or should not be understood as indicating or implying a sequence.

It should be noted that identical reference numerals in the accompanying drawings of this application denote identical or similar structures. Therefore, repeated description thereof is omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

To facilitate understanding of the technical solutions provided in embodiments of this application, the following first describes an application scenario of the solutions of this application. Solar energy has the advantages of abundant resources, long life, wide distribution, safety, cleanliness, and reliable technology. Utilizing solar energy for power generation features no noise, no pollution, and high reliability, holding a good application prospect in the field of new energy power generation. A photovoltaic system provided in embodiments of this application generates power based on solar energy, is applicable to outputting electric energy to an alternating current grid by using a grid-connected transformer, and is also applicable to supplying power to a base station device (for example, a base station device in a remote area with no mains supply or poor mains supply), or supplying power to a battery, or supplying power to a plurality of types of electric devices such as a home device (for example, a refrigerator or an air conditioner) in the alternating current grid. This may be specifically determined based on an actual application scenario, and is not limited herein.

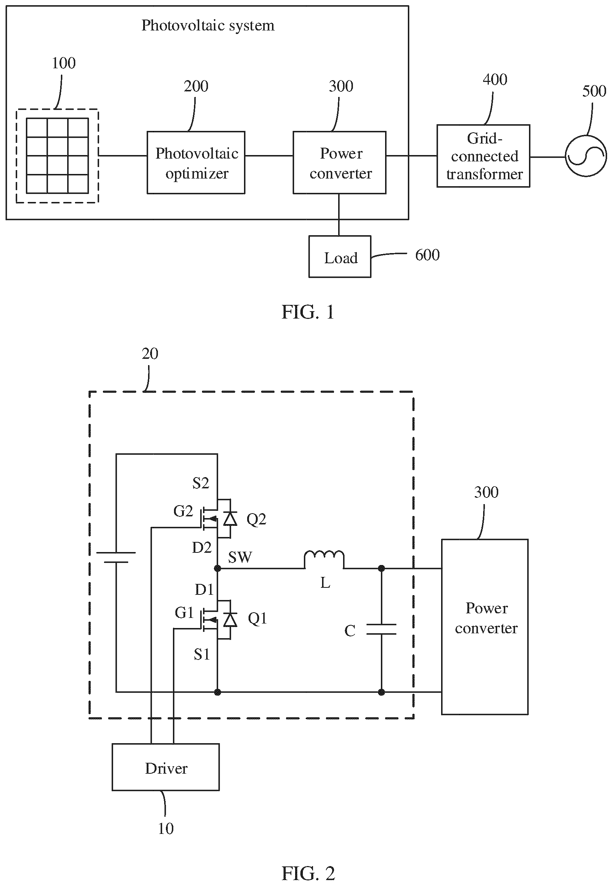

FIG. 1 is a diagram of an application scenario of a photovoltaic system according to an embodiment of this application. As shown in FIG. 1, the photovoltaic system includes a photovoltaic module 100, a photovoltaic optimizer 200, and a power converter 300. An input end of the photovoltaic optimizer 200 is connected to the photovoltaic module 100, and an output end of the photovoltaic optimizer 200 is connected to an input end of the power converter 300. In the photovoltaic system, the photovoltaic module 100 may convert sunlight into a direct current by using a photovoltaic effect. For example, the photovoltaic module 100 may be a photovoltaic array or a photovoltaic module group. One photovoltaic module group may be formed by connecting one or more photovoltaic strings in parallel, and one photovoltaic string may be obtained by connecting one or more photovoltaic modules in series. The photovoltaic module herein may also be referred to as a solar cell module. In other words, the photovoltaic module may include all photovoltaic modules in one solar panel that are connected in series and/or in parallel, or may include some photovoltaic modules in one solar panel that are connected in series and/or in parallel.

In addition, the photovoltaic optimizer 200 has a maximum power point tracking (Maximum Power Point Tracking, MPPT) function, that is, the photovoltaic optimizer 200 may perform maximum power point tracking on the photovoltaic module, so that the photovoltaic module 100 maintains a high output power. The direct current output by the photovoltaic module 100 is converted by the photovoltaic optimizer and then output to the power converter 300. The power converter 300 may convert the received direct current into an alternating current or a direct current. For example, the power converter 300 may include an inverter, or may include a direct current converter. This may be specifically determined based on an actual application scenario, and is not limited herein. The inverter may convert a received direct current into an alternating current to supply power to a load 600. The load 600 may include an alternating current load such as a communication base station or a home device in the alternating current grid. Alternatively, the inverter may convert a received direct current into an alternating current, and the alternating current is output to the alternating current grid 500 through conversion by the grid-connected transformer 400, to implement grid connection. The direct current converter may convert a received direct current into another direct current that meets a load requirement to supply power to the load. The load may include a direct current load such as a battery. In addition, the photovoltaic optimizer uses the MPPT function to cause the photovoltaic system to operate at global MPPT, improving power generation efficiency.

It may be understood that, in the photovoltaic system, there may be a plurality of photovoltaic modules and a plurality of photovoltaic optimizers, each photovoltaic optimizer may be connected to one or more photovoltaic modules, and output ends of the plurality of photovoltaic optimizers are connected in series and/or in parallel and then connected to the power converter. When costs of the photovoltaic optimizer are low, the photovoltaic system may configure one photovoltaic optimizer for each photovoltaic module, so that an output power of each photovoltaic module reaches a maximum output power. This can improve power generation efficiency of the system.

The photovoltaic optimizer uses a software algorithm and a circuit topology to implement the MPPT function. In this way, a problem that power generation yield of the photovoltaic system decreases due to photovoltaic module shading and orientation differences is resolved, to achieve a maximum power output of the photovoltaic module, and improve power generation efficiency of the photovoltaic system. FIG. 2 is a schematic of a circuit topology in a photovoltaic optimizer according to an embodiment of this application. The photovoltaic optimizer includes a driver 10 and a power conversion circuit 20. The power conversion circuit 20 includes a first MOS transistor Q1, a second MOS transistor Q2, a power inductor L, and a capacitor C. A source S1 of the first MOS transistor Q1 is connected to a negative electrode of the photovoltaic module and negative ends of a first end and an output end. A drain D1 of the first MOS transistor Q1 is connected to a switch (Switch, SW) control pin. A gate G1 of the first MOS transistor Q1 is connected to the driver. A source S2 of the second MOS transistor Q2 is connected to a positive electrode of the photovoltaic module. A drain D2 of the second MOS transistor Q2 is connected to the switch control pin. A gate G2 of the second MOS transistor Q2 is connected to the driver. A first end of the power inductor L is connected to the switch control pin, and a second end of the power inductor is connected to a positive end of the output end. A first end of the capacitor C is connected to the positive end of the output end, and a second end of the capacitor C is connected to the negative end of the output end. The driver inputs a drive signal to the gate G1 of the first MOS transistor Q1 and the gate G2 of the second MOS transistor Q2, to control the first MOS transistor Q1 and the second MOS transistor Q2 to be turned on and turned off. This achieves an objective of controlling an output voltage and an output current. It may be understood that the schematic of the circuit topology shown in FIG. 2 is merely an example. In actual application, the power conversion circuit may further be set to a Boost circuit, a Buck-Boost circuit, a Cuk circuit, a full-bridge circuit, or the like. This is not limited in this application.

In an actual product, the first MOS transistor and the second MOS transistor are usually disposed in a package structure. However, with industry requirements, switching frequencies of the first MOS transistor and the second MOS transistor are increasingly high. In processes of frequently turning on and turning off the first MOS transistor and the second MOS transistor, a magnetic field that changes at a high frequency is generated in a surrounding environment, and a high-order harmonic component is induced in a circuit. If the circuit is directly connected to the power grid, a high-order harmonic wave is injected into the power grid, deteriorating electric energy quality of the power grid. In addition, during operation, large currents up to tens of amperes may usually flow through the first MOS transistor and the second MOS transistor. If the first MOS transistor and the second MOS transistor are frequently turned on and turned off, switching losses and conduction losses are generated in the first MOS transistor and the second MOS transistor, and these energy losses may be released in a form of heat energy. If the heat energy released by the first MOS transistor and the second MOS transistor cannot be transferred to the outside in time, the first MOS transistor and the second MOS transistor are exposed to a risk of being burnt out at a high temperature. This affects overall reliability of the package structure. In addition, in the conventional technology, to implement heat dissipation and electromagnetic shielding, the foregoing circuit topology is usually disposed on a plurality of layers of metal substrates, resulting in a complex structure, a large quantity of production and processing processes, and difficulty in reducing a module height. This indirectly increases an overall size of the photovoltaic optimizer. As a result, production costs are increased, interface thermal resistance is increased, and heat dissipation efficiency is low. Therefore, embodiments of this application provide a package structure. This can implement heat dissipation and electromagnetic shielding, and improve overall reliability of a package module. In addition, this can simplify a structure, simplify a manufacturing process, reduce a module size, and reduce production costs.

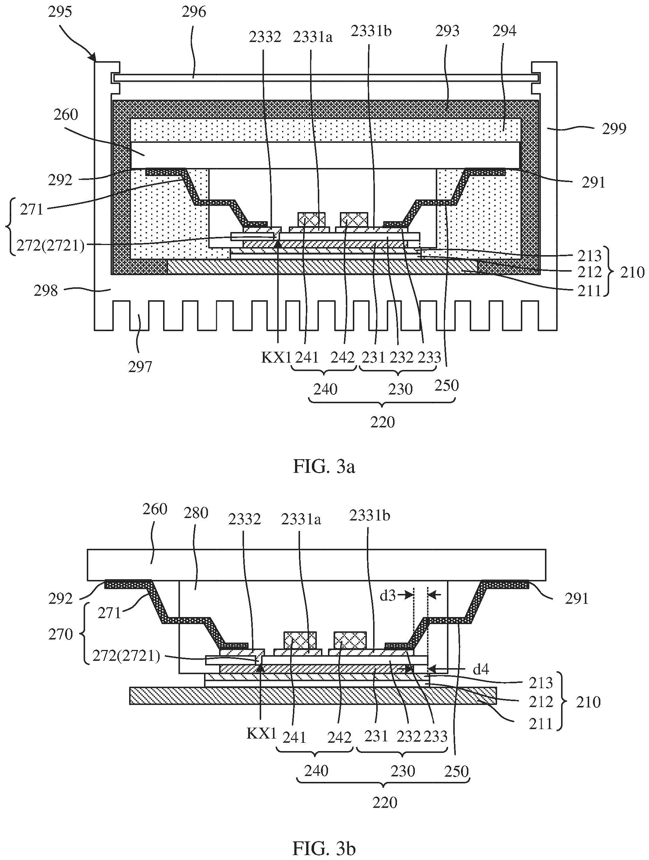

FIG. 3a is a diagram of a structure of a photovoltaic optimizer according to an embodiment of this application. FIG. 3b is a diagram of a structure of a package structure according to an embodiment of this application. As shown in FIG. 3a and FIG. 3b, the photovoltaic optimizer includes a first housing 295 and a package structure. The first housing 295 may be made of a metal material, or may be made of another material with relatively ideal heat dissipation performance. In addition, specifically, the first housing 295 may include a cover plate 296, a bottom plate 298, and a side wall 299. The side wall 299 is fastened between the cover plate 296 and the bottom plate 298. The cover plate 296, the bottom plate 298, and the side wall 299 form a closed structure having accommodation space, and the package structure is disposed in the accommodation space. In other words, the first housing 295 has the accommodation space inside, and the package structure is disposed inside the first housing 295. In addition, the package structure includes a first substrate 210, a package module 220, a circuit board 260, and a conductor 270. The package module 220 is located between the first substrate 210 and the circuit board 260. The first substrate 210 includes a first metal layer 213, an insulation layer 212, and a metal substrate 211 that are sequentially disposed in a stacked manner. The first metal layer 213 is located on a side that is of the insulation layer 212 and that faces a second substrate 230, and a surface of a side that is of the metal substrate 211 and that faces away from the insulation layer 212 is in direct contact with an inner wall of a side that is of the bottom plate 298 and that faces the cover plate 296. In addition, an outer wall of a side that is of the bottom plate 298 and that faces away from the cover plate 296 is provided with a heat dissipation protrusion 297 or a heat dissipation fin extending outward. Based on this, the first substrate 210 is used as a baseboard of the package module 220, and the metal substrate 211 is directly in contact with the inner wall of the bottom plate 298. The outer wall of the bottom plate 298 is provided with the heat dissipation protrusion 297 or the heat dissipation fin, and the heat dissipation protrusion 297 or the heat dissipation fin can increase a heat dissipation area of the bottom plate 298. In this way, heat on the first substrate 210 can be dissipated to the outside as soon as possible via a path sequentially passing through the metal substrate 211, the bottom plate 298, and the heat dissipation protrusion 297 or the heat dissipation fins. Moreover, the first substrate 210 may further provide functions such as protection and support for the package module 220.

In addition, the package module 220 includes the second substrate 230, a power device 240, and a first pin 250. The second substrate 230 includes a second metal layer 231, an insulation substrate 232, and a third metal layer 233 that are sequentially disposed in a stacked manner. The power device 240 is located on a surface of a side that is of the third metal layer 233 and that faces away from the insulation substrate 232, the third metal layer 233 has a drive line (for example, 2331a and 2331b) connected to the power device 240, and the first pin 250 connects the drive line to a drive pad 291 on the circuit board 260. In addition, the circuit board 260 is, for example, a printed circuit board (Printed circuit board, PCB) 260. A driver is disposed on the circuit board 260, and the driver is connected to the drive pad 291. Based on this, the second substrate 230 is used as a package carrier of the power device 240, for providing functions such as electrical connection, protection, support, heat dissipation, and assembly for the power device 240. In addition, when the package module 220 operates, heat generated by the power device 240 may be transferred to the first substrate 210 via the second substrate 230. Because the metal substrate 211 in the first substrate 210 is in contact with the first housing 295, the heat transferred to the first substrate 210 can be directly transferred to the bottom plate 298, and the heat is dissipated to the outside via the bottom plate 298 and the heat dissipation protrusion 297 or the heat dissipation fin. In this way, the heat generated by the power device 240 is dissipated by combining the first substrate 210, the second substrate 230, the bottom plate 298, and the heat dissipation protrusion 297 or the heat dissipation fin. This can simplify a structure, reduce a module size, and reduce costs. In addition, this can further reduce total thermal resistance on a heat conducting path, dissipate the heat generated by the power device 240 to the outside as soon as possible in time, and improve a heat dissipation function.

It may be understood that the outer wall of the bottom plate 298 may be provided with a plurality of heat dissipation protrusions 297 or heat dissipation fins, so that the heat dissipation area of the bottom plate 298 can be increased, to improve heat dissipation efficiency of the bottom plate 298 and further improve heat dissipation efficiency of the photovoltaic optimizer. Specifically, the heat dissipation protrusion 297 or the heat dissipation fin may be made of a metal material or the like. When the heat dissipation protrusion 297 or the heat dissipation fin and the first housing 295 are both made of a metal material, the heat dissipation protrusion 297 or the heat dissipation fin may be integrally formed with the bottom plate 298. For example, the bottom plate and the side wall in the first housing 295 may be integrally formed, and the bottom plate and the side wall may be clamped, welded, or riveted using a screw, to form the closed structure having the accommodation space.

Still refer to FIG. 3a. The photovoltaic optimizer further includes a second housing 293, and the second housing 293 also has accommodation space inside. For example, the second housing 293 may be in a cuboid shape, a cylindrical shape, or the like. The shape of the second housing 293 is not limited in this embodiment of this application. The second housing 293 may be made of a plastic material or a metal material. The material of the second housing 293 is not limited in this embodiment of this application, either.

As shown in FIG. 3a, the package structure is disposed inside the second housing 293. To further improve the heat dissipation function, the second housing 293 is filled with a heat-conducting medium 294 as a whole, and the heat-conducting medium 294 is a potting material or the like. In this way, the heat-conducting medium 294 and the package structure are used to fill internal space of the second housing 293, and the heat-conducting medium 294 is in contact with the package structure, accelerating heat dissipation of the package structure.

In addition, to improve the heat dissipation function, a side that is of the second housing 293 and that faces away from the metal substrate 211 is provided with a first opening, and the metal substrate 211 is in contact with the first housing 295 through the first opening, so that heat on the metal substrate 211 can be directly dissipated via the first housing 295. In addition, in actual application, the first housing is further connected to a ground, to connect the metal substrate to the ground, implementing grounding protection.

In addition, an inner wall of the first housing 295 may be in contact with an outer wall of the second housing 293. Therefore, this can accelerate heat dissipation of a device inside the second housing 293, and this further helps the second housing 293 resist an external force. In addition, a shape of the first housing 295 may adapt to the shape of the second housing 293. For example, when the first housing 295 has one bottom plate, four side walls, and one cover plate, the second housing 293 may also have one bottom plate, four side walls, and one cover plate, and the bottom plate, the four side walls, and the cover plate form closed space.

Further, the heat dissipation protrusion 297 or the heat dissipation fin may be disposed on a side, that is of the first housing 295 and that faces away from the metal substrate 211, and extends outward. Specifically, the bottom plate of the second housing 293 is in contact with the bottom plate of the first housing 295, and the heat dissipation protrusion 297 or the heat dissipation fin may be disposed on the bottom plate that is of the first housing 295 and that faces away from the metal substrate 211, so that the heat dissipation protrusion 297 or the heat dissipation fin may be disposed close to the metal substrate 211, accelerating heat dissipation of the metal substrate 211. In addition to being disposed on the bottom plate of the first housing 295, the heat dissipation protrusion 297 or the heat dissipation fin may alternatively be disposed on the side wall of the first housing 295.

In actual application, a mounting ear structure may be disposed on the first housing 295, so that the first housing is mounted and connected to another structure. Specifically, the mounting ear structure may be made of a metal material. The mounting ear structure may be of a plate structure, and the mounting ear structure may be disposed on a side that is of the cover plate of the first housing 295 and that faces away from the bottom plate.

In addition, considering a heat dissipation requirement of the power device 240, during specific implementation, the second substrate 230 may be disposed as a copper-clad ceramic (direct bonding copper, DBC) substrate or a copper-plated ceramic (Direct Plate Copper, DPC) substrate, so that each of the second metal layer 231 and the third metal layer 233 is made of copper. In this case, the heat generated when the power device 240 operates is dissipated to the outside as soon as possible by using excellent heat conducting performance of the DBC or the DPC, to further improve a heat dissipation function. It may be understood that the second metal layer 231 and the third metal layer 233 may alternatively be made of another metal material with good heat conducting performance, that is, the second substrate 230 is disposed as another type of substrate to improve heat dissipation.

Further, to dissipate the heat generated by the power device 240 to the outside as soon as possible, the first substrate 210 may further be disposed as an aluminum substrate with a good heat dissipation function, to further reduce total thermal resistance on the heat conducting path and improve the heat dissipation function.

In actual application, the power device 240 may include some or all devices in the power conversion circuit. A quantity and an arrangement of devices included in the power device 240 may be specifically determined based on implementation of hardware performance of the package structure, a hardware electrical connection requirement of the package structure, and the like. This is not limited in this embodiment of this application. For example, as shown in FIG. 3a and FIG. 3b, the power device 240 includes a first power device 241 and a second power device 242. The first power device 241 may be a first MOS transistor, and the second power device 242 may be a second MOS transistor. The first MOS transistor is correspondingly disposed at a position in which 241 is located, and the second MOS transistor is correspondingly disposed at a position in which 242 is located. In addition, with reference to the circuit topology diagram shown in FIG. 2, a plurality of drive lines are needed. The plurality of drive lines include a plurality of signal wires with different functions, such as a drive line 2331a that is correspondingly connected to the first MOS transistor, a drive line 2331b that is correspondingly connected to the second MOS transistor, a signal wire for signal input and output, a ground line, and a line for power supply voltage input. This application is described by using an example in which the drive line includes 2331a and 2331b. In addition, each of the drive lines that are correspondingly connected to the first MOS transistor and the second MOS transistor needs to be connected to a corresponding drive pad 291 on the circuit board 260 by using a corresponding first pin 250. A driver is disposed on the circuit board 260, and the driver is connected to the drive pad 291, so that the driver inputs drive signals to the first MOS transistor and the second MOS transistor, and controls the first MOS transistor and the second MOS transistor to be turned on and turned off. Certainly, when the power device 240 further includes a power inductor L and a capacitor C, the third metal layer 233 is further provided with a drive line corresponding to the power device 240. In addition, it may be understood that, in FIG. 3a and FIG. 3b, an example in which the drive line 2331b corresponding to the second MOS transistor is connected to the drive pad 291 by using the corresponding first pin 250 is used for illustration. Other drive lines with different functions may be connected to the corresponding drive pad by using the corresponding first pin, and the other drive lines are connected to the drive pad 291 by using the first pin 250 in a same manner. Details are not described herein again.

Still refer to FIG. 3a and FIG. 3b. An orthographic projection that is of the second metal layer 231 and that is on the circuit board 260 covers an orthographic projection that is of the power device 240 and that is on the circuit board 260, and the conductor 270 connects the second metal layer 231 to a ground potential pad 292 on the circuit board 260, so that the second metal layer 231 can be connected to a ground potential. Moreover, a surface of a side that is of the second metal layer 231 and that faces away from the insulation substrate 232 is connected to a surface of a side that is of the first metal layer 213 and that faces away from the insulation layer 212, so that the second metal layer 231 and the first metal layer 213 may be combined with each other to serve as an electromagnetic shield layer. This implements electromagnetic shielding for a magnetic field generated by the power device, especially implements an electromagnetic compatibility (Electromagnetic compatibility, EMC) shielding function at an SW point. In addition, the insulation layer 212 in the first substrate 210 can be used to implement insulation, simplifying a structure design and reducing production difficulty and costs.

During specific implementation, the surface of the side that is of the second metal layer 231 and that faces away from the insulation substrate 232 may be directly welded to the surface of the side that is of the first metal layer 213 and that faces away from the insulation layer 212 in a welding manner, so that the surface of the side that is of the second metal layer 231 and that faces away from the insulation substrate 232 is in direct contact with the surface of the side that is of the first metal layer 213 and that faces away from the insulation layer 212. In this way, heat conducted to the second metal layer 231 can be directly conducted to the first metal layer 213, and then dissipated to the outside as soon as possible via the insulation layer 212 and the metal substrate 211, improving the heat dissipation function. Alternatively, the surface of the side that is of the second metal layer 231 and that faces away from the insulation substrate 232 and the surface of the side that is of the first metal layer 213 and that faces away from the insulation layer 212 may be connected together by using a thermal interface material. In this way, heat conducted to the second metal layer 231 can be conducted to the first metal layer 213 by using the thermal interface material, and then dissipated to the outside as soon as possible via the insulation layer 212 and the metal substrate 211.

Still refer to FIG. 3a and FIG. 3b. The conductor 270 includes a second pin 271 and a conversion member 272. The third metal layer 233 is further provided with a conversion part 2332 that is insulated from the drive lines 2331a and 2331b. The insulation substrate 232 is provided with a through connection hole KX1. The conversion member 272 electrically connects the conversion part 2332 to the second metal layer 231 through the connection hole KX1. The second pin 271 connects the conversion part 2332 to the ground potential pad 292 on the circuit board 260. Based on this, the insulation substrate 232 is provided with the connection hole KX1, and the conversion member 272 is disposed in the connection hole KX1. In this way, the second pin 271, the conversion part 2332, and the conversion member 272 are used to connect the second metal layer 231 and the first metal layer 213 to the ground potential pad 292, so that the second metal layer 231 and the first metal layer 213 have the ground potential. This ensures stability and reliability of a structure and enhances system reliability.

During specific implementation, to reduce resistance of the conversion member 272, a material of the conversion member 272 is set to a metal material. Further, to reduce contact resistance, the material of the conversion member 272 may be the same as a material of the third metal layer 233 and a material of the second metal layer 231. For example, when the second substrate 230 is a DBC or a DPC, the conversion member 272 is made of copper.

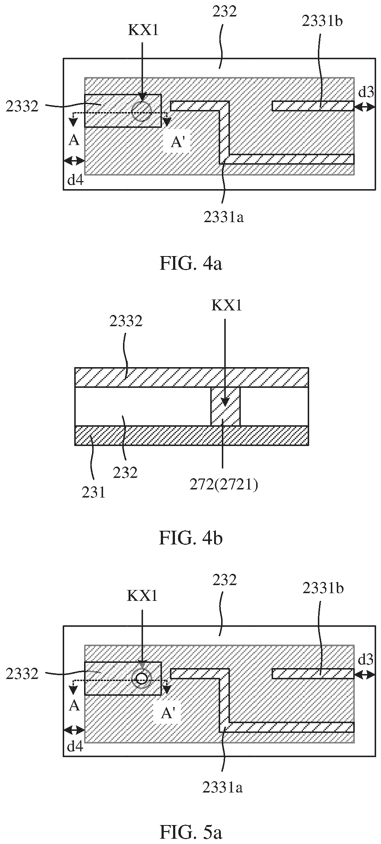

A structure of the conversion member 272 in this application may be implemented in a plurality of manners. In some examples, FIG. 4a is a top-view diagram of a structure of a second substrate according to an embodiment of this application. FIG. 4b is a sectional diagram of a structure in an AA' direction in FIG. 4a. The conversion member 272 may be disposed as a metal material layer 2721 with which the connection hole KX1 is filled. During process preparation, the metal material layer 2721 is deposited in the connection hole KX1 by using a metal material, so that the metal material layer 2721 fills the connection hole KX1, and the metal material layer 2721 and the conversion part 2332 are electrically connected to each other. In this way, the metal material layer 2721 and the second pin 271 may be used to ground the first metal layer 213 and the second metal layer 231, to implement the electromagnetic shielding function. In addition, the metal material layer 2721 and the second pin 271 are used to ground the first metal layer 213 and the second metal layer 231, so that stability and reliability of a structure can be ensured, and system reliability can be enhanced.

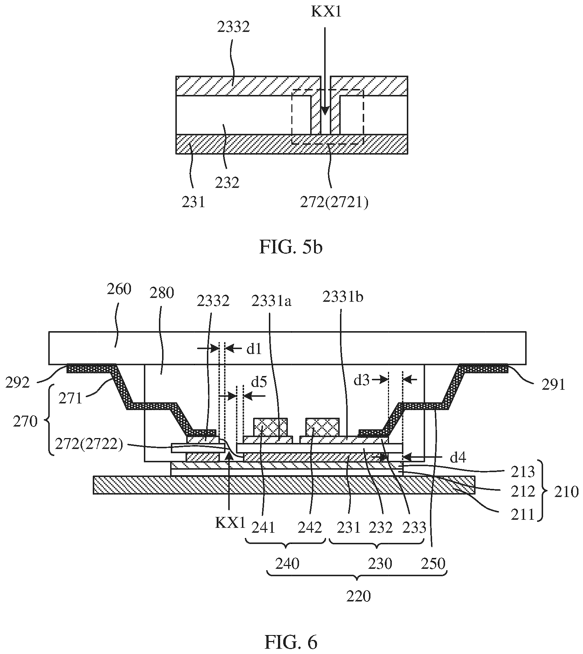

In some other examples, FIG. 5a is a top-view diagram of a structure of another second substrate according to an embodiment of this application. FIG. 5b is a sectional diagram of a structure in an AA' direction in FIG. 5a. The conversion member 272 may be disposed as a metal material layer 2721 covering a side wall of the connection hole KX1. During process preparation, the metal material layer 2721 is deposited on the side wall of the connection hole KX1 by using a metal material, so that the metal material layer 2721 and the conversion part 2332 are electrically connected to each other. In this way, the metal material layer 2721 and the second pin 271 may be used to ground the first metal layer 213 and the second metal layer 231, to implement the electromagnetic shielding function.

As shown in FIG. 4a and FIG. 5a, the second metal layer 231 may be disposed as an entire-plane structure, and a shape of the second metal layer 231 is approximately the same as a shape of the insulation substrate 232. In addition, to implement a safety regulation requirement, a fourth spacing d4 may exist between an edge of the second metal layer 231 and an edge of the insulation substrate 232. The fourth spacing d4 is greater than or equal to a third specified safety regulation distance, to meet the safety regulation requirement. In addition, a third spacing d3 exists between the drive line and the edge of the insulation substrate 232. The third spacing d3 is greater than or equal to the third specified safety regulation distance, to meet the safety regulation requirement. For example, the third spacing may be the same as the fourth spacing. Certainly, the third spacing may alternatively be greater than or less than the fourth spacing.

As shown in FIG. 3a and FIG. 3b, considering a requirement for electromagnetic shielding, an orthographic projection that is of the first metal layer 213 and that is on the circuit board 260 covers orthographic projections that are of the second metal layer 231 and the third metal layer 233 and that are on the circuit board 260. Alternatively, an orthographic projection that is of the first metal layer 213 and that is on the circuit board 260 overlaps orthographic projections that are of the second metal layer 231 and the third metal layer 233 and that are on the circuit board 260. Further, the orthographic projection that is of the first metal layer 213 and that is on the circuit board 260 covers an orthographic projection that is of the second substrate 230 and that is on the circuit board 260, so that electromagnetic shielding can be further performed on magnetic fields generated by the first MOS transistor and the second MOS transistor. Alternatively, the orthographic projection that is of the first metal layer 213 and that is on the circuit board 260 may overlap an orthographic projection that is of the second substrate 230 and that is on the circuit board 260.

In actual application, the metal substrate 211 is further in contact with the housing, and the housing is connected to the ground, so that the metal substrate 211 is connected to the ground. However, during operation, large currents up to tens of amperes may usually flow through the first MOS transistor and the second MOS transistor. Considering the safety regulation requirement, during specific implementation, a thickness of the insulation layer 212 further needs to be greater than or equal to 0.2 mm, to meet a requirement of enhanced insulation in the safety regulation. Further, an orthographic projection that is of the insulation layer 212 and that is on the circuit board 260 can further cover the orthographic projection that is of the first metal layer 213 and that is on the circuit board 260, to meet a requirement of enhanced insulation between the first metal layer 213 and the metal substrate 211. During specific implementation, the insulation layer 212 is made of, for example, a polypropylene (polypropylene, PP) material. Certainly, the insulation layer 212 may alternatively be made of another material that can implement enhanced insulation. This is not limited herein.

Still refer to FIG. 3a and FIG. 3b. The package module 220 further includes a package adhesive 280. The package adhesive 280 wraps at least a side that is of the second metal layer 231 and that faces the insulation substrate 232, that is, wraps both the insulation substrate 232 and the power device 240. In addition, the package adhesive 280 further wraps some regions of the first pin 250. Specifically, a first end of the first pin 250 is connected to the drive line 2331b, and a second end of the first pin 250 extends to the outside of the package adhesive 280 and is connected to the drive pad 291. In addition, the package adhesive 280 exposes the surface of the side that is of the second metal layer 231 and that faces away from the insulation substrate 232, so that the surface of the side that is of the second metal layer 231 and that faces away from the insulation substrate 232 can be connected to a surface of a side that is of the first metal layer 213 and that faces the second metal layer 231, improving a heat dissipation function. Moreover, the side that is of the second metal layer 231 and that faces the insulation substrate 232 is wrapped by using the package adhesive 280, so that lines in the third metal layer 233 and the power device 240 may further be protected.

In addition, as shown in FIG. 3a and FIG. 3b, when the conductor 270 includes the second pin 271 and the conversion member 272, the package adhesive 280 further wraps some regions of the second pin 271. Specifically, a first end of the second pin 271 is electrically connected to the conversion part 2332, and a second end of the second pin 271 extends to the outside of the package adhesive 280 and is connected to the ground potential pad 292.

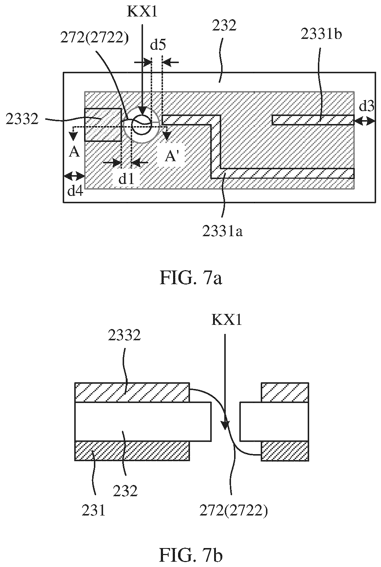

FIG. 6 is a diagram of a structure of another package structure according to an embodiment of this application. FIG. 7a is a top-view diagram of a structure of another second substrate according to an embodiment of this application. FIG. 7b is a sectional diagram of a structure in an AA' direction in FIG. 7a. As shown in FIG. 6 to FIG. 7b, the package structure includes a first substrate 210, a package module 220, a circuit board 260, and a conductor 270. A difference between this embodiment and the embodiment shown in FIG. 3b lies in that a conversion member 272 is disposed as a metal wire 2722. Other content in this embodiment may be basically the same as the content in the embodiment shown in FIG. 3b. Details are not described herein.

As shown in FIG. 6 to FIG. 7b, the conversion member 272 is disposed as the metal wire 2722. The metal wire 2722 may be formed by using a wire bonding (wire bonding, WB) process, so that the metal wire 2722 passes through a connection hole KX1 to electrically connect a conversion part 2332 to a second metal layer 231. In this way, the metal wire 2722 and a second pin 271 may be used to ground a first metal layer 213 and the second metal layer 231, to implement an electromagnetic shielding function. In addition, the metal wire 2722 and the second pin 271 are used to ground the first metal layer 213 and the second metal layer 231, so that stability and reliability of a structure can be ensured, and system reliability can be enhanced. Certainly, the conversion member 272 may alternatively be disposed as a metal strip. This is not limited herein.

As shown in FIG. 6 to FIG. 7b, to implement a safety regulation requirement, the connection hole KX1 is provided with a top of a side facing away from the first substrate 210. A first spacing d1 exists between the conversion part 2332 and an edge of the top of the connection hole KX1. The first spacing d1 is greater than or equal to a first specified safety regulation distance, to meet the safety regulation requirement. A fifth spacing d5 exists between the drive line and the edge of the top of the connection hole KX1. The fifth spacing d5 is greater than or equal to the first specified safety regulation distance, to meet the safety regulation requirement. For example, the first spacing may be the same as the fifth spacing. Certainly, the first spacing may alternatively be greater than or less than the fifth spacing.

As shown in FIG. 6 to FIG. 7b, to implement the safety regulation requirement, the connection hole KX1 is provided with a bottom of a side facing the first substrate 210. A second spacing d2 exists between the second metal layer 231 and an edge of the bottom of the connection hole KX1. The second spacing d2 is greater than or equal to a second specified safety regulation distance, to meet the safety regulation requirement.

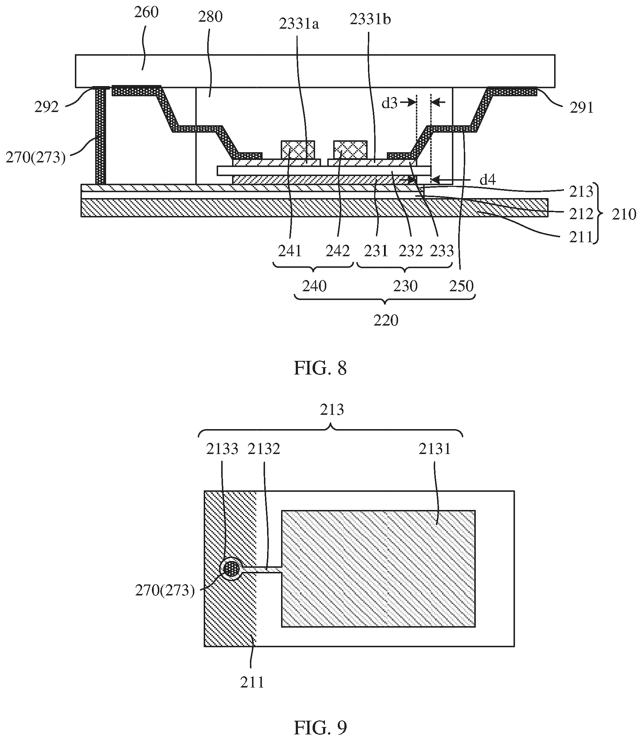

FIG. 8 is a diagram of a structure of another package structure according to an embodiment of this application. FIG. 9 is a top-view diagram of a structure of a first substrate according to an embodiment of this application. As shown in FIG. 8 and FIG. 9, the package structure includes a first substrate 210, a package module 220, a circuit board 260, and a conductor 270. A difference between this embodiment and the embodiment shown in FIG. 3b lies in that the conductor 270 is disposed as a metal column 273. Other content in this embodiment may be basically the same as the content in the embodiment shown in FIG. 3b. Details are not described herein.

As shown in FIG. 8 and FIG. 9, the conductor 270 is disposed as the metal column 273. A first end of the metal column 273 is connected to a ground potential pad 292 on the circuit board 260, and a second end of the metal column 273 is connected to a first metal layer 213. In this way, the metal column 273 may be used to ground the first metal layer 213 and a second metal layer 231, to implement an electromagnetic shielding function. In addition, the metal column 273 is used to ground the first metal layer 213 and the second metal layer 231, so that stability and reliability of a structure can be ensured, and system reliability can be enhanced.

During specific implementation, the metal column 273 may be disposed as a metal copper column. Certainly, the metal column 273 may alternatively be disposed as a metal column of another material. This is not limited herein.

As shown in FIG. 9, the first metal layer 213 may have a shield component 2131, a shield line 2132, and a shield connection component 2133. The shield component 2131 may be of an entire-plane structure. A surface of a side that is of the shield component 2131 and that faces away from an insulation layer 212 is connected to a surface of a side that is of the second metal layer 231 and that faces away from an insulation substrate 232 through welding or by using a thermal interface material. In addition, the shield component 2131 is electrically connected to the shield connection component 2133 by using the shield line 2132, and the shield connection component 2133 is connected to the second end of the metal column 273. In this way, the metal column 273 may be used to ground the first metal layer 213 and the second metal layer 231. Certainly, the first metal layer 213 may alternatively be disposed as an entire-plane structure. This is not limited herein.

The foregoing descriptions are merely specific implementations of this application, but are not intended to limit the protection scope of this application. Any variation or replacement readily figured out by a person skilled in the art in the technical scope disclosed in this application shall fall within the protection scope of this application.

## Claims

1. A photovoltaic optimizer, comprising a first housing and a package structure, wherein
the first housing comprises a cover plate, a bottom plate, and a side wall, the side wall is fastened between the cover plate and the bottom plate, an outer wall of a side that is of the bottom plate and that faces away from the cover plate is provided with a heat dissipation protrusion or a heat dissipation fin extending outward, the cover plate, the bottom plate, and the side wall form a closed structure having accommodation space, and the package structure is disposed in the accommodation space;
the package structure comprises a first substrate, a package module, a circuit board, and a conductor, the first substrate comprises a first metal layer, an insulation layer, and a metal substrate that are sequentially disposed in a stacked manner, the first metal layer is located on a side that is of the insulation layer and that facesa second substrate, and a surface of a side that is of the metal substrate and that faces away from the insulation layer is in direct contact with an inner wall of a side that is of the bottom plate and that faces the cover plate;
the package module comprises the second substrate, a power device, and a first pin, the second substrate comprises a second metal layer, an insulation substrate, and a third metal layer that are sequentially disposed in a stacked manner, the power device is located on a surface of a side that is of the third metal layer and that faces away from the insulation substrate, the third metal layer has a drive line connected to the power device, and the first pin connects the drive line to a drive pad on the circuit board; and
an orthographic projection that is of the second metal layer and that is on the circuit board covers an orthographic projection that is of the power device and that is on the circuit board, the conductor connects the second metal layer to a ground potential pad on the circuit board, and a surface of a side that is of the second metal layer and that faces away from the insulation substrate is connected to a surface of a side that is of the first metal layer and that faces away from the insulation layer.

2. The photovoltaic optimizer according to claim 1, further comprising a second housing, wherein the second housing is accommodated inside the first housing, the package structure is disposed inside the second housing, a side that is of the second housing and that faces away from the metal substrate is provided with a first opening, and the surface of the side that is of the metal substrate and that faces away from the insulation layer is in contact with the bottom plate through the first opening; and
the second housing is further filled with a heat-conducting medium, and the heat-conducting medium and the package structure fill internal space of the second housing.

3. The photovoltaic optimizer according to claim 1 or 2, wherein an orthographic projection that is of the first metal layer and that is on the circuit board covers an orthographic projection that is of the second substrate and that is on the circuit board.

4. The photovoltaic optimizer according to claim 3, wherein an orthographic projection that is of the insulation layer and that is on the circuit board covers the orthographic projection that is of the first metal layer and that is on the circuit board.

5. The photovoltaic optimizer according to any one of claims 1 to 4, wherein the third metal layer is further provided with a conversion part that is insulated from the drive line, and the insulation substrate is provided with a through connection hole; and
the conductor comprises a second pin and a conversion member, the conversion member electrically connects the conversion part to the second metal layer through the connection hole, and the second pin connects the conversion part to the ground potential pad.

6. The photovoltaic optimizer according to claim 5, wherein the conversion member is a metal material layer covering a side wall of the connection hole; or
the conversion member is a metal material layer with which the connection hole is filled.

7. The photovoltaic optimizer according to claim 5, wherein the conversion member comprises a metal strip or a metal wire.

8. The photovoltaic optimizer according to claim 7, wherein the connection hole is provided with a top of a side facing away from the first substrate, a first spacing exists between the conversion part and an edge of the top of the connection hole, a fifth spacing exists between the drive line and the edge of the top of the connection hole, and the first spacing and the fifth spacing are greater than or equal to a first specified safety regulation distance.

9. The photovoltaic optimizer according to claim 7 or 8, wherein the connection hole is provided with a bottom of a side facing the first substrate, a second spacing exists between the second metal layer and an edge of the bottom of the connection hole, and the second spacing is greater than or equal to a second specified safety regulation distance.

10. The photovoltaic optimizer according to any one of claims 1 to 4, wherein the conductor comprises a metal column; and
a first end of the metal column is connected to the ground potential pad on the circuit board, and a second end of the metal column is connected to the first metal layer.

11. The photovoltaic optimizer according to any one of claims 1 to 10, wherein a third spacing exists between the drive line and an edge of the insulation substrate, and a fourth spacing exists between the second metal layer and the edge of the insulation substrate; and
each of the third spacing and the fourth spacing is greater than or equal to a third specified safety regulation distance.

12. The photovoltaic optimizer according to any one of claims 1 to 11, wherein the first substrate comprises an aluminum substrate; and/or
the second substrate comprises a ceramic copper-clad plate or a copper-plated insulation substrate.

13. The photovoltaic optimizer according to any one of claims 1 to 12, wherein the package module further comprises a package adhesive, the package adhesive wraps at least a side that is of the second metal layer and that faces the power device, a first end of the first pin is connected to the drive line, and a second end of the first pin extends to the outside of the package adhesive and is connected to the drive pad.

14. The photovoltaic optimizer according to claim 13, wherein when the conductor comprises the second pin and the conversion member, a first end of the second pin is electrically connected to the conversion part, and a second end of the second pin extends to the outside of the package adhesive and is connected to the ground potential pad.

15. A package structure, comprising a first substrate, a package module, a circuit board, and a conductor, wherein the first substrate comprises a first metal layer, an insulation layer, and a metal substrate that are sequentially disposed in a stacked manner, and the first metal layer is located on a side that is of the insulation layer and that facesa second substrate;
the package module comprises the second substrate, a power device, and a first pin, the second substrate comprises a second metal layer, an insulation substrate, and a third metal layer that are sequentially disposed in a stacked manner, the power device is located on a surface of a side that is of the third metal layer and that faces away from the insulation substrate, the third metal layer has a drive line connected to the power device, and the first pin connects the drive line to a drive pad on the circuit board; and
an orthographic projection that is of the second metal layer and that is on the circuit board covers an orthographic projection that is of the power device and that is on the circuit board, the conductor connects the second metal layer to a ground potential pad on the circuit board, and a surface of a side that is of the second metal layer and that faces away from the insulation substrate is connected to a surface of a side that is of the first metal layer and that faces away from the insulation layer.
